# EUROPÄISCHE PATENTANMELDUNG

(11) **EP 2 364 073 A2**
(43) Veröffentlichungstag der Anmeldung: **07.09.2011**
(21) Anmeldenummer: 11156028.0
(22) Anmeldetag: 25.02.2011
(51) Int. Cl.: H05K 5/00

(54) **Elektrische Komponente für ein Fahrzeug**

(30) Priorität: 02.03.2010 DE 102010009824
(71) Anmelder: Behr-Hella Thermocontrol GmbH, 70190 Stuttgart (DE)
(72) Erfinder: Fust, Winfried, 59556, Lippstadt (DE)
(74) Vertreter: von Kreisler, Alek

(57) **Zusammenfassung**

Die elektrische Komponente, insbesondere elektrische Schaltung, für ein Fahrzeug ist versehen mit einem Gehäuse (10,10') und einem in dem Gehäuse (10,10') angeordneten Trägerelement (16) mit einer mindestens einen ersten Anschlussstift (22) aufweisenden ersten Gruppe (18) von von dem Trägerelement (16) aufragenden Anschlussstiften. Ferner weist die elektrische Komponente eine zum Trägerelement (16) hin offene erste Aussparung (26) im Gehäuse (10) auf, die einen zum Trägerelement (16) weisenden umlaufenden Rand (30) aufweist und in die der mindestens eine erste Anschlussstift (22) hineinragt. Schließlich ist die elektrische Komponente mit einem gegenüber dem Gehäuse (10) separat ausgeführten ersten Führungselement (38) zur Führung eines ersten Anschlusssteckers für den mindestens einen ersten Anschlussstift (22) versehen, wobei das Führungselement (38) mit Spiel in die erste Aussparung (26) des Gehäuses (10) eingesetzt ist und eine der Anzahl an ersten Anschlussstiften (22) gleichende Anzahl an Durchführungsöffnungen (50) für die ersten Anschlussstifte (22) aufweist und wobei das Trägerelement (16) mit einer mindestens einen zweiten Anschlussstift (24) aufweisenden zweiten Gruppe (20) von von dem Trägerelement (16) aufragenden Anschlussstiften (24) versehen ist, die in eine als Vertiefung ausgebildete zweite Aussparung (28) des Gehäuses (10) hineinragen, welche einen zum Trägerelement (16) weisenden umlaufenden Rand (32) zur Führung eines zweiten Anschlusssteckers aufweist, wobei die zweite Aussparung (28) einen mit dem Aussparungsrand (32) verbundene Bodenwand (34) aufweist, die eine der Anzahl an zweiten Anschlussstiften (24) gleichende Anzahl an Durchführungsöffnungen (36) für die zweiten Anschlussstifte (24) aufweist.

## Beschreibung

Die Erfindung betrifft eine elektrische Komponente für ein Fahrzeug, wie beispielsweise eine elektrische Schaltung, die in einem Gehäuse untergebracht ist und die Anschlussstifte aufweist, an die ein Anschlussstecker anschließbar ist.

Elektrische Schaltungen für Fahrzeuge müssen unter anderem feuchtigkeits-und spritzwassergeschützt in Gehäusen untergebracht sein. Für die elektrische Kontaktierung verwendet man sogenannte Steckerkörbe, die am bzw. im Gehäuse angeordnet sind und der Aufnahme von Anschlusssteckern dienen. Die Steckerkörbe weisen mehrere Einzelkontakte auf, die innerhalb einer Fassung in Form eines Kragens o.dgl. angeordnet sind, wobei die Fassung bzw. der Kragen der Aufnahme und Führung eines Anschlusssteckers dient (siehe z. B. DE-U-91 00 962.6).

Es ist bekannt, die Steckerkörbe als vom Gehäuse separate Einheit, die bereits die Einzelkontakte beinhaltet, mit einem Trägerelement, bei dem es sich im Regelfall um eine Schaltungsplatine handelt, starr zu verbinden (siehe z. B. DE-A-100 17 335), Allerdings sind derartige Konzepte relativ kostenintensiv. Daher geht man dazu über, die Einzelkontakte, bei denen es sich im Regelfall um Anschlussstifte handelt, einzeln auf dem Trägerelement anzuordnen und in dem Gehäuse eine Aussparung vorzusehen, in die die Anschlussstifite hineinragen. Die Aussparung weist dabei einen zum Trägerelement weisenden umlaufenden Rand und einen mit dem Rand verbundenen Boden auf, der mit Durchführungsöffnungen für die einzelnen Anschlussstifite versehen ist. Bei diesem Konzept ist die Fassung des Steckerkorbs in Form der Aussparung ausgebildet und damit integraler Bestandteil des Gehäuses. Durch die Montage des Trägerelements (Leiterkarte) mit den Anschlussstiften in dem Gehäuse wird der Stecker komplettiert.

Die Position der Anschlussstifte bezogen auf die Aussparung im Gehäuse sind für die Funktion des Steckersystems von großer Bedeutung und daher eng toleriert. Aus diesem Grund wird das Gehäuse bei diesem bekannten Konzept an zwei Referenzkontakten innerhalb der Steckerkörbe zentriert. In dieses bekannte Konzept fließen Toleranzen der beteiligten Bauteile in die Positionsgenauigkeit ein. Insbesondere bei der Konzeption mit mehreren Steckerkörben können die werkstoffbedingten und aus anderen Gründen unvermeidbaren Toleranzen im (Kunststoff-)Gehäuse dazu führen, dass die Anforderungen an die Positionstoleranz der Steckerstifte zum Steckerkorb (Taumelkreis) nicht realisiert werden können,

Andere elektrische Komponenten bzw. Baugruppen mit Gehäusen und einem oder mehreren Steckerkörben sind aus DE-A-103 46 990, DE-A-10 2007 061 817, DE-A-10 2007 061 818 und US-A-2009/0264008 bekannt.

Aufgabe der Erfindung ist es, eine elektrische Komponente für ein Fahrzeug zu schaffen, die über ein vereinfachtes und bezüglich der einzuhaltenden Toleranzen vorteilhaftes Steckerkorbkonzept verfügt.

Zur Lösung dieser Aufgabe wird mit der Erfindung eine elektrische Komponente, insbesondere eine elektrische Schaltung, für ein Fahrzeug vorgeschlagen, wobei die Komponente versehen ist mit:
- einem Gehäuse,
- einem in dem Gehäuse angeordneten Trägerelement mit einer mindestens einen ersten Anschlussstift aufweisenden ersten Gruppe von von dem Trägerelement aufragenden Anschlussstiften,
- einer zum Trägerelement hin offenen ersten Aussparung im Gehäuse, die einen zum Trägerelement weisenden umlaufenden Rand aufweist und in die der mindestens eine erste Anschlussstift hineinragt, und
- einem gegenüber dem Gehäuse separat ausgeführten ersten Führungselement zur Führung eines ersten Anschlusssteckers für den mindestens einen ersten Anschlussstift,
- wobei das Führungselement mit Spiel in die erste Aussparung des Gehäuses eingesetzt ist und eine der Anzahl an ersten Anschlussstiften gleichende Anzahl an Durchführungsöffnungen für die ersten Anschlussstifte aufweist und
- wobei das Trägerelement mit einer mindestens einen zweiten Anschlussstift aufweisenden zweiten Gruppe von von dem Trägerelement aufragenden Anschlussstiften versehen ist, die in eine als Vertiefung ausgebildete zweite Aussparung des Gehäuses hineinragen, welche einen zum Trägerelement weisenden umlaufenden Rand zur Führung eines zweiten Anschlusssteckers aufweist, wobei die zweite Aussparung einen mit dem Aussparungsrand verbundene Bodenwand aufweist, die eine der Anzahl an zweiten Anschlussstiften gleichende Anzahl an Durchführungsöffnungen für die zweiten Anschlussstifte aufweist.

Die erfindungsgemäße elektrische Komponente, insbesondere elektrische Schaltung, für ein Fahrzeug weist ein Gehäuse auf, in dem ein Trägerelement angeordnet ist, das neben einer elektrischen Schaltung mit Leiterbahnen und Bauteilen auch mit einer ersten Gruppe von von dem Trägerelement aufragenden Anschlussstiften versehen ist, welche mindestens einen ersten Anschlussstift aufweist. In dem Gehäuse (beispielsweise an der Oberseite des Gehäuses) befindet sich eine erste Aussparung, die zum Trägerelement hin offen ist und einen zum Trägerelement weisenden umlaufenden Rand aufweist. In diese erste Aussparung ragt der mindestens eine erste Anschlussstift hinein.

Erfindungsgemäß ist nun in diese erste Aussparung des Gehäuses ein vom Gehäuse getrennt ausgebildetes erstes Führungselement eingesetzt, und zwar mit allseitigem Spiel. Mit anderen Worten ist das erste Führungselement also sozusagen "schwimmend" in der ersten Aussparung angeordnet. Das erste Führungselement ist mit einer der Anzahl an ersten Anschlussstiften gleichenden Anzahl an Durchführungsöffnungen für die ersten Anschlussstifte versehen.

Die getrennte Ausbildung von Gehäuse und Führungselement macht es möglich, dass sich das Führungselement bei der Montage der elektrischen Komponente auf die Anschlussstifte des Trägerelements selbstständig ausrichtet. Das Führungselement ist mit Spiel in die erste Aussparung eingesetzt und kann mit dem Gehäuse verclipst oder auf andere Art und Weise an dem Gehäuse gehaltert sein, Gegenüber dem Gehäuse ist das Führungselement zumindest während der Montage bewegbar in der Aussparung angeordnet. In der zentrierten Position, die das Führungselement nach der Montage einnimmt, braucht es nicht mehr notwendigerweise verschiebbar und bewegbar in der Aussparung angeordnet zu sein. Vorteilhaft ist es allerdings, wenn im montierten Zustand eine Bewegung des Führungselements behindert bzw unterbunden ist.

Gemäß der Erfindung ist das Konzept des schwimmenden Steckerkorbs mit einem im Gehäuse integrierten Steckerkorb kombiniert, Hierzu ist vorgesehen, dass das Trägerelement mit einer mindestens einen zweiten Anschlussstift aufweisenden zweiten Gruppe von von dem Trägerelement aufragenden Anschlussstiften versehen ist, die in eine als Vertiefung ausgebildete zweite Aussparung des Gehäuses hineinragen, welche einen zum Trägerelement weisenden umlaufenden Rand zur Führung eines zweiten Anschlusssteckers aufweist, wobei die zweite Aussparung einen mit dem Aussparungsrand verbundene Bodenwand aufweist, die eine der Anzahl an zweiten Anschlussstiften gleichende Anzahl an Durchführungsöffnungen für die zweiten Anschlussstifte aufweist.

Mit dem erfindungsgemäßen Konzept konnte nachgewiesen werden, dass "Taumelkreise" mit Vorgaben realisiert werden können, wie es bei bekannten Konzepten bisher nicht möglich war. Die erreichbaren Toleranzen sind dabei abhängig von den verwendeten Materialien für das Gehäuse und den Abmessungen der Steckerkörbe und des Gehäuses.

Die getrennte Ausführung von Führungselement und Gehäuse hat darüber hinaus einen weiteren Vorteil. Je nach Einsatzumgebung der elektrischen Komponente und den Anforderungen der Fahrzeughersteller müssen die Steckerkörbe bestimmten Werkstoffanforderungen genügen (beispielsweise einen erhöhten Entflammschutz aufweisen). Sofern der Steckerkorb fester Bestandteil des Gehäuses ist, muss zur Erfüllung dieser Spezifikation das gesamte Gehäuse in dem die Spezifikation erfüllenden Werkstoff ausgeführt sein, was je nach Rohstoffpreis eine Verteuerung des Gehäuses gegenüber anderen technisch gleichwertigen Werkstoffen zur Folge hat. Bei dem erfindungsgemäßen Konzept kann nun das Führungselement, das den Steckerkorb bildet, aus einem ersten Werkstoff bestehen, der die Steckerkorb-Spezifikation erfüllt, während für das Gehäuse ein anderer zweiter Werkstoff gewählt werden kann, der unabhängig von spezifischen Vorgaben ausgewählt werden kann. Vorteilhaft ist es also, dass das erste Führungselement und das Gehäuse unterschiedliche Materialien, insbesondere unterschiedliche Kunststoffmaterialien aufweisen können.

In vorteilhafter Weiterbildung der Erfindung kann die elektrische Komponente mehrere schwimmende Steckerkörbe aufweisen. Hierbei ist vorgesehen, dass das Trägerelement mit einer mindestens einen zweiten Anschlussstift aufweisenden zweiten Gruppe von von dem Trägerelement aufragenden Anschlussstiften versehen ist, die in eine zum Trägerelement hin offene zweite Aussparung des Gehäuses hineinragen, welche einen zum Trägerelement weisenden umlaufenden Rand aufweist und in welche mit Spiel ein zweites Führungselement zur Führung eines zweiten Anschlusssteckers eingesetzt ist, wobei das zweite Führungselement eine der Anzahl an zweiten Anschlussstiften gleichende Anzahl von Durchführungsöffnungen für die zweiten Anschlussstifte aufweist.

Jedes Führungselement ist zweckmäßigerweise mit einem in die zugehörige Aussparung des Gehäuses hineinragenden Führungskragen versehen, von dem ein Außenflansch abragt, an dem der Aussparungsrand des Gehäuses anliegt. Das Führungselement selbst liegt vorteilhafterweise verschiebbar auf dem Trägerelement auf. Der Kragen erstreckt in diesem Ausführungsbeispiel bis zum Trägerelement, wobei der Kragen einen Boden umschließt, in dem die Durchführungsöffnungen für die Anschlussstifte ausgebildet sind. Dieser Boden verläuft im Regelfall in Höhe des Endes des Aussparungsrandes und sorgt für einen Abschluss des Innenraums des Gehäuses nach außen hin.

Ferner ist es möglich, an der elektrischen Komponente drei oder mehr Steckerkörbe vorzusehen, wobei einer der Steckerkörbe einstückig mit dem Gehäuse und die anderen Steckerkörbe schwimmend ausgeführt ist bzw. sind.

Die Erfindung wird nachfolgend anhand mehrerer Ausführungsbeispiele und unter Bezugnahme auf die Zeichnung näher erläutert. Im Einzelnen zeigen dabei:
- Fig. 1: einen Schnitt durch ein Gehäuse mit einer elektrischen Schaltung und zwei einstückig mit dem Gehäuse ausgeführten Steckerkörben nach dem Stand der Technik (z. B. DE-U-91 00 962.6),
- Fig. 2: eine perspektivische Ansicht eines Gehäuses für eine elektrische Schaltung mit einem einstückig mit dem Gehäuse ausgeführten Steckerkorb und einem erfindungsgemäß ausgeführten schwimmenden Steckerkorb und
- Fig. 3: eine Schnittansicht entlang der Linie III-III der Fig. 2 zur Verdeutlichung des Aufbaus des Gehäuses gemäß Fig. 2.

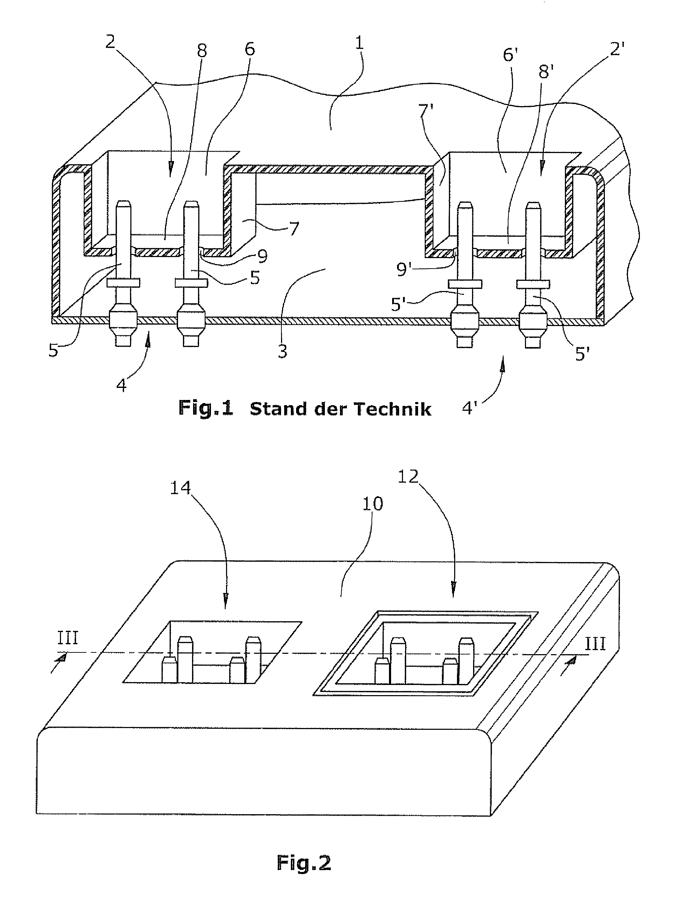

Fig 1 zeigt eine Schnittansicht durch ein Gehäuse 1 mit zwei Steckerkörben 2,2', die gemäß dem Stand der Technik einstückig mit dem Gehäuse 1 ausgebildet sind. In dem Gehäuse 1 ist ein Trägerelement 3 (Leiterkarte o.dgl.) mit einer (nicht dargestellten) elektrischen Schaltung angeordnet. Das Trägerelement 3 weist zwei Gruppen 4,4' von Anschlussstiften 5 bzw, 5' auf, die von dem Trägerelement 3 aufragen. Den beiden Gruppen 4,4' von Anschlussstiften sind zwei Aussparungen 6,6' in der Oberseite des Gehäuses 1 zugeordnet, wobei jede Aussparung 6,6' von einem umlaufenden Rand 7 bzw. 7' begrenzt ist und zum Innern des Gehäuses 1 hin durch eine Bodenwand 8 bzw. 8' abgeschlossen ist. In den Bodenwänden 8,8' sind Durchführungsöffnungen 9,9' für die Anschlussstifte 5,5' ausgebildet. Dieses bekannte Konzept erfordert die Einhaltung verringerter Toleranzen, was werkstoffbedingt und aus anderen fertigungstechnischen Gründen mit erhöhten Anforderungen verbunden ist. Dies verteuert die Herstellung des Gehäuses und dessen Montage.

In den Fign. 2 bis 4 sind Ausführungsbeispiele nach der Erfindung gezeigt. Gemäß Fig. 2 weist ein Gehäuse 10 eines ersten Ausführungsbeispiels der Erfindung zwei Steckerkörbe 12,14 auf, wobei der erste Steckerkorb 12 vom Gehäuse 10 getrennt und der zweite Steckerkorb 14 einstückig mit dem Gehäuse 10 ausgebildet ist.

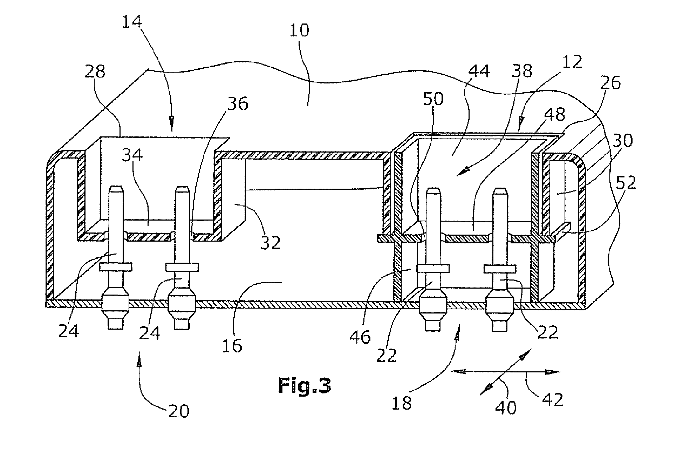

Wie insbesondere anhand von Fig. 3 zu erkennen ist, ragen von einem Trägerelement 16 in Form einer Leiterkarte zwei Gruppen 18,20 von Anschlussstiften 22,24 auf, die beispielsweise mit dem Trägerelement 16 verpresst sind. Die Steckerkörbe 12,14 weisen Aussparungen 26 bzw. 28 in dem Gehäuse 10 auf, wobei jede Aussparung von einem umlaufenden Rand 30 bzw. 32 begrenzt ist, der sich zum Trägerelement 16 hin erstreckt bzw. erstrecken kann, Die Aussparung 26 für den schwimmend ausgeführten ersten Steckerkorb 12 ist zum Trägerelement 16 hin offen, während die zweite Aussparung 28 des einstückig mit dem Gehäuse 10 ausgebildeten zweiten Steckerkorbs 14 eine Bodenwand 34 mit Durchführungsöffnungen 36 für die Anschlussstifte 24 aufweist.

In die erste Aussparung 26 ist ein Führungselement 38 mit Spiel eingesetzt (siehe die Pfeile 40,42 in Fig. 3, die die beiden Bewegungsfreiheitsgrade des Führungselements 38 in der Aussparung 26 andeuten). Das Führungselement 38 weist einen oberen Führungskragen 44 sowie einen unteren Auflagekragen 46 auf, über den das Führungselement 38 auf dem Trägerelement 16 aufliegt. Zwischen beiden Krägen 44,46 erstreckt sich eine Bodenwand 48 mit Durchführungsöffnungen 50 für die Anschlussstifte 22. Der Führungskragen 44 erstreckt sich innerhalb des Aussparungsrandes 30 und dient der Führung und Aufnahme eines (nicht dargestellten) Anschlusssteckers. In Höhe der Bodenwand 48 weist das Führungselement 38 einen Außenflansch 52 auf, an dem der Aussparungsrand 30 anliegt.

Die Führungs- und Aufnahmefunktion, wie sie vorstehend für den schwimmenden Steckerkorb 12 beschrieben ist, wird bei dem einstückig mit dem Gehäuse 10 ausgeführten Steckerkorb 14 durch den Aussparungsrand 32 der Aussparung 28 des Steckerkorbs 14 realisiert.

Wie in Fig. 3 durch die Schraffur angedeutet, können das Führungselement 38 und das Gehäuse 10 aus unterschiedlichen insbesondere Kunststoffmaterialien bestehen. Dies kann je nach Anwendungsfall von Vorteil sein, und zwar insbesondere dann, wenn für den Bereich des Gehäuses 10 um eine Gruppe von Anschlussstiften herum ein kostspieligeres, weil speziellen Anforderungen zu genügendes Material verwendet werden muss, als im übrigen Bereich des Gehäuses 10. Als Beispiel für einen solchen Fall sei auf den Flammschutz verwiesen.

Anhand von Fig. 3 und der vorstehenden Beschreibung wird aber auch deutlich, dass die Anforderungen an die Einhaltung von Toleranzen bei diesem Gehäuse- und Steckerkorbkonzept geringer sind als bei dem Gehäuse 1 nach Fig. 1, Bei dem Gehäuse 10 gemäß Fig. 3 zentriert sich das Führungselement 38 auf die Anschlussstifte 22 selbsttätig. Hier müssen also die Bemaßung der Durchführungsöffnungen 50, des Führungselements 38 und der Aussparung 26 aufeinander abgestimmt sein. Diese Komponenten liegen sämtlich auf engem Raum, so dass die Einhaltung der Toleranzen ohne weiteres möglich ist. Eine Abstimmung dieser Toleranzen auf die übrigen bei der Montage des Gehäuses 10 zu beachtenden Toleranzen ist nicht erforderlich, was den Herstellungs-und Montageprozess des Gehäuses 10 vereinfacht.

### BEZUGSZEICHENLISTE

- 1: Gehäuse
- 2: integrierter Steckerkorb
- 2': integrierter Steckerkorb
- 3: Trägerelement
- 4: erste Gruppe von Anschlussstiften
- 4': zweite Gruppe von Anschlussstiften
- 5: Anschlussstifte
- 5': Anschlussstifte
- 6: Aussparung im Gehäuse
- 6': Aussparung im Gehäuse
- 7: Aussparungsrand
- 7': Aussparungsrand
- 8: Bodenwand
- 8': Bodenwand
- 9: Durchführungsöffnungen in Bodenwand
- 9': Durchführungsöffnungen in Bodenwand
- 10: Gehäuse
- 12: erster Steckerkorb
- 14: zweiter Steckerkorb
- 16: Trägerelement
- 18: erste Gruppe von Anschlussstiften
- 20: zweite Gruppe von Anschlussstiften
- 22: erste Anschlussstifte
- 24: zweite Anschlussstifte
- 26: erste Aussparung
- 28: Aussparung
- 30: Aussparungsrand
- 32: Aussparungsrand
- 34: Bodenwand
- 36: Durchführungsöffnungen in Bodenwand

- 38: Führungselement
- 44: Führungskragen des Führungselements
- 46: Auflagekragen des Führungselements
- 48: Bodenwand
- 50: Durchführungsöffnungen
- 52: Außenflansch

## Patentansprüche

1. Elektrische Komponente für ein Fahrzeug, mit
- einem Gehäuse (10,10'),
- einem in dem Gehäuse (10,10') angeordneten Trägerelement (16) mit einer mindestens einen ersten Anschlussstift (22) aufweisenden ersten Gruppe (18) von von dem Trägerelement (16) aufragenden Anschiussstiften,
- einer zum Trägerelement (16) hin offenen ersten Aussparung (26) im Gehäuse (10), die einen zum Trägerelement (16) weisenden umlaufenden Rand (30) aufweist und in die der mindestens eine erste Anschlussstift (22) hineinragt, und
- einem gegenüber dem Gehäuse (10) separat ausgeführten ersten Führungselement (38) zur Führung eines ersten Anschlusssteckers für den mindestens einen ersten Anschlussstift (22),
- wobei das Führungselement (38) mit Spiel in die erste Aussparung (26) des Gehäuses (10) eingesetzt ist und eine der Anzahl an ersten Anschlussstiften (22) gleichende Anzahl an Durchführungsöffnungen (50) für die ersten Anschlussstifte (22) aufweist und
- wobei das Trägerelement (16) mit einer mindestens einen zweiten Anschlussstift (24) aufweisenden zweiten Gruppe (20) von von dem Trägerelement (16) aufragenden Anschlussstiften (24) versehen ist, die in eine als Vertiefung ausgebildete zweite Aussparung (28) des Gehäuses (10) hineinragen, welche einen zum Trägerelement (16) weisenden umlaufenden Rand (32) zur Führung eines zweiten Anschlusssteckers aufweist, wobei die zweite Aussparung (28) einen mit dem Aussparungsrand (32) verbundene Bodenwand (34) aufweist, die eine der Anzahl an zweiten Anschlussstiften (24) gleichende Anzahl an Durchführungsöffnungen (36) für die zweiten Anschlussstifte (24) aufweist.

2. Elektrische Komponente nach Anspruch 1, **dadurch gekennzeichnet, dass** das erste Führungselement (38) und das Gehäuse (10) unterschiedliche Materialien, insbesondere unterschiedliche Kunststoffmaterialien aufweisen.

3. Elektrische Komponente nach Anspruch 1 oder 2, **dadurch gekennzeichnet, dass** das Trägerelement (16) mit mindestens einer weiteren, mindestens einen weiteren Anschlussstift aufweisenden Gruppe von von dem Trägerelement (16) aufragenden Anschlussstiften versehen ist, die in eine zum Trägerelement (16) hin offene weitere Aussparung des Gehäuses hineinragen, welche einen zum Trägerelement (16) weisenden umlaufenden Rand aufweist und in welche mit Spiel ein weiteres Führungselement zur Führung eines weiteren Anschlusssteckers eingesetzt ist, wobei das weitere Führungselement eine der Anzahl an weiteren Anschlussstiften gleichende Anzahl von Durchführungsöffnungen für die weiteren Anschlussstifte aufweist.

4. Elektrische Komponente nach einem der Ansprüche 1 bis 3, **dadurch gekennzeichnet, dass** das Trägerelement (16) mit einer mindestens einen zweiten Anschlussstift aufweisenden zweiten Gruppe von von dem Trägerelement (16) aufragenden Anschlussstiften versehen ist, die in eine zum Trägerelement (16) hin offene zweite Aussparung des Gehäuses (10) hineinragen, welche einen zum Trägerelement (16) weisenden umlaufenden Rand aufweist und in welche mit Spiel ein zweites Führungselement zur Führung eines zweiten Anschlusssteckers eingesetzt ist, wobei das zweite Führungselement eine der Anzahl an zweiten Anschlussstiften gleichende Anzahl von Durchführungsöffnungen für die zweiten Anschlussstifte aufweist.

5. Elektrische Komponente nach einem der Ansprüche 1 bis 4, **dadurch gekennzeichnet, dass** das erste Führungselement (38) bzw. jedes Führungselement einen in die zugehörige Aussparung (26) des Gehäuses (10) hineinragenden Führungskragen (44) und einen an diesem ausgebildeten Flansch (52) aufweist, an dem der Rand (30) der Aussparung (26) des Gehäuses (10) anliegt.

6. Elektrische Komponente nach einem der Ansprüche 1 bis 5, **dadurch gekennzeichnet, dass** das erste Führungselement (38) bzw, jedes Führungselement (38) verschiebbar auf dem Trägerelement (16) aufliegt.
